# EUROPEAN PATENT APPLICATION

(11) **EP 4 621 827 A1**
(43) Date of publication of application: **24.09.2025**
(21) Application number: 24219748.1
(22) Date of filing: 13.12.2024
(51) Int. Cl.: H01L 21/18, H01L 21/02, H01L 23/00

(54) **SUBSTRATE BONDING METHOD AND SUBSTRATE BONDING APPARATUS**

(30) Priority: 19.03.2024 JP 2024043677
(71) Applicant: SCREEN Holdings Co., Ltd., Kyoto-shi, Kyoto 602-8585 (JP)
(72) Inventor: SHIMIZU, Hideki, Kyoto, 602-8585 (JP); HASHIMOTO, Koji, Kyoto, 602-8585 (JP); MUTO, Shogo, Kyoto, 602-8585 (JP); FUJIOKA, Ryota, Kyoto, 602-8585 (JP); KOMATSU, Teruyuki, Kyoto, 602-8585 (JP); OSAWA, Atsushi, Kyoto, 602-8585 (JP)
(74) Representative: Kilian Kilian & Partner mbB

(57) **Abstract**

A substrate bonding method includes a plasma processing step of processing a bonding surface of each of the substrates with a rare gas plasma which is a plasma of a rare gas, processing the bonding surface of each of the substrates processed with the rare gas plasma with a hydrogen plasma which is a plasma of hydrogen, and processing the bonding surface of each of the substrates processed with the hydrogen plasma with a nitrogen plasma which is a plasma of nitrogen and a substrate bonding step of bonding two substrates by bringing the bonding surfaces of the two substrates into contact with each other such that copper pads of the two substrates face each other and insulating films of the two substrates face each other after the plasma processing step.

## Description

### BACKGROUND OF THE INVENTION

### 1. Field of the Invention

The present invention relates to a substrate bonding method and a substrate bonding apparatus that bond two substrates.

### 2. Description of Related Art

JP 2024-6789 A discloses a semiconductor device including a first substrate and a second substrate bonded to each other. Paragraph 0061 of JP 2024-6789 A describes that "a second substrate 2 on which a second connection wiring layer 22 is formed and the first substrate 3 are bonded together. In this state, O of copper oxide (CuO, Cu₂O, or the like) is present on the bonding surface X between the first electrode 33 and the second electrode 23."

At least one embodiment of the present invention provides a substrate bonding method and a substrate bonding apparatus that can bond two substrates in a state where copper oxide is removed from the surfaces of copper pads.

### SUMMARY OF THE INVENTION

An embodiment of the present invention provides a substrate bonding method that bonds two substrates each having a bonding surface where a copper oxide of a copper pad and an insulating film are exposed. The substrate bonding method includes a plasma processing step of processing the bonding surface of each of the substrates with a rare gas plasma which is a plasma of a rare gas, processing the bonding surface of each of the substrates processed with the rare gas plasma with a hydrogen plasma which is a plasma of hydrogen, and processing the bonding surface of each of the substrates processed with the hydrogen plasma with a nitrogen plasma which is a plasma of nitrogen and a substrate bonding step of bonding the two substrates by bringing the bonding surfaces of the two substrates into contact with each other such that the copper pads of the two substrates face each other and the insulating films of the two substrates face each other after the plasma processing step.

In the embodiment, at least one of the following features may be added to the substrate bonding method.

The plasma processing step is a step of performing, on each of the two substrates, a rare gas plasma processing step of processing the bonding surface with a plasma containing the rare gas plasma and not containing the nitrogen plasma, a nitrogen plasma processing step of processing the bonding surface with the nitrogen plasma, and a hydrogen plasma processing step of processing the bonding surface with the hydrogen plasma simultaneously with at least one of the rare gas plasma processing step and the nitrogen plasma processing step, or after the rare gas plasma processing step and before the nitrogen plasma processing step.

The plasma processing step is a step of performing, on each of the two substrates, a first plasma processing step of supplying a first reaction gas containing the rare gas and hydrogen and not containing nitrogen into an airtight container containing the substrate and processing the bonding surface with a first plasma generated from the first reaction gas, and a second plasma processing step of supplying a second reaction gas containing nitrogen into the airtight container and processing the bonding surface with a second plasma generated from the second reaction gas.

The substrate bonding method further includes an oxygen contact step of bringing at least one of oxygen in atmosphere and oxygen in a liquid into contact with the bonding surface of each of the substrates after the plasma processing step is performed.

The oxygen contact step includes a cleaning step of cleaning with a cleaning liquid and drying each of the two substrates after the plasma processing step is performed and before the substrate bonding step is performed.

The substrate bonding method further includes a heat processing step of heating the two bonded substrates to directly couple copper contained in the copper pad of one of the two substrates to copper contained in the copper pad of the other of the two substrates.

The plasma processing step is a step of processing the bonding surface of each of the substrates with the rare gas plasma, the hydrogen plasma, and the nitrogen plasma by causing a plasma processing unit of a substrate bonding apparatus to generate the rare gas plasma, the hydrogen plasma, and the nitrogen plasma, the substrate bonding step is a step of bonding the two substrates by causing a bonding unit of the substrate bonding apparatus to bring the bonding surfaces of the two substrates into contact with each other such that the copper pads of the two substrates face each other and the insulating films of the two substrates face each other, and the heat processing step is a step of directly coupling copper contained in the copper pad of one of the two substrates and copper contained in the copper pad of the other of the two substrates by causing a heat processing unit of the substrate bonding apparatus to heat the bonded two substrates.

The plasma processing step is a step of generating an inductively coupled plasma of at least one of the rare gas, hydrogen, and nitrogen by supplying a high-frequency current to an antenna disposed in a space between an inner plate that closes a hole opened in an inner surface of an outer wall of an airtight container accommodating the substrate and an outer plate that closes a hole opened in an outer surface of the outer wall.

Another embodiment of the present invention provides a substrate bonding apparatus that bonds two substrates each having a bonding surface where a copper oxide of a copper pad and an insulating film are exposed. The substrate bonding apparatus includes a plasma processing unit configured to process the bonding surface of each of the substrates with a rare gas plasma which is a plasma of a rare gas, process the bonding surface of each of the substrates processed with the rare gas plasma with a hydrogen plasma which is a plasma of hydrogen, and process the bonding surface of each of the substrates processed with the hydrogen plasma with a nitrogen plasma which is a plasma of nitrogen and a substrate bonding unit configured to bond the two substrates by bringing the bonding surfaces of the two substrates into contact with each other such that the copper pads of the two substrates face each other and the insulating films of the two substrates face each other after the bonding surface of each of the substrates is processed with the rare gas plasma, the hydrogen plasma, and the nitrogen plasma. At least one of the above-described features relating to the substrate bonding method may be added to the substrate bonding apparatus.

In the embodiment, at least one of the following features may be added to the substrate bonding apparatus.

The plasma processing unit performs, on each of the two substrates, a rare gas plasma processing step of processing the bonding surface with a plasma containing the rare gas plasma and not containing the nitrogen plasma, a nitrogen plasma processing step of processing the bonding surface with the nitrogen plasma, and a hydrogen plasma processing step of processing the bonding surface with the hydrogen plasma simultaneously with at least one of the rare gas plasma processing step and the nitrogen plasma processing step, or after the rare gas plasma processing step and before the nitrogen plasma processing step.

The plasma processing unit performs, on each of the two substrates, a first plasma processing step of supplying a first reaction gas containing the rare gas and hydrogen and not containing nitrogen into an airtight container containing the substrate and processing the bonding surface with a first plasma generated from the first reaction gas and a second plasma processing step of supplying a second reaction gas containing nitrogen into the airtight container and processing the bonding surface with a second plasma generated from the second reaction gas.

The substrate bonding apparatus further includes an oxygen contact unit configured to bring at least one of oxygen in atmosphere and oxygen in a liquid into contact with the bonding surface of each of the substrates after the bonding surface of each of the substrates is processed with the rare gas plasma, the hydrogen plasma, and the nitrogen plasma.

The oxygen contact unit includes a cleaning unit configured to clean with a cleaning liquid and dry each of the two substrates after the bonding surface of each of the substrates is processed with the rare gas plasma, the hydrogen plasma, and the nitrogen plasma and before the two substrates are bonded.

The substrate bonding apparatus further includes a heat processing unit configured to heat the two bonded substrates to directly couple copper contained in the copper pad of one of the two substrates to copper contained in the copper pad of the other of the two substrates.

The plasma processing unit generates an inductively coupled plasma of at least one of the rare gas, hydrogen, and nitrogen by supplying a high-frequency current to an antenna disposed in a space between an inner plate that closes a hole opened in an inner surface of an outer wall of an airtight container accommodating the substrate and an outer plate that closes a hole opened in an outer surface of the outer wall.

### BRIEF DESCRIPTION OF THE DRAWINGS

FIG. 1 is a schematic view illustrating two substrates before being bonded.
FIGS. 2A and 2B are schematic views illustrating cross-sections of the two substrates before and after being bonded.
FIGS. 3A to 3F are schematic diagrams for explaining an example of a procedure from processing of a substrate with plasma to heating of the two bonded substrates.
FIGS. 4A to 4F are schematic diagrams for illustrating an example of a change that is assumed to occur on the surface of a copper pad when a substrate is processed with plasma or heated.
FIG. 5 is a schematic view of a substrate bonding apparatus.
FIG. 6 is a schematic view showing a vertical cross-section of a plasma processing unit.

### DETAILED DESCRIPTION OF PREFERRED EMBODIMENTS

Embodiments of the present invention will be explained in detail with reference to the accompanying drawings.

First, two substrates W to be bonded will be described. When the two substrates W are distinguished, these are referred to as a first substrate W1 and a second substrate W2.

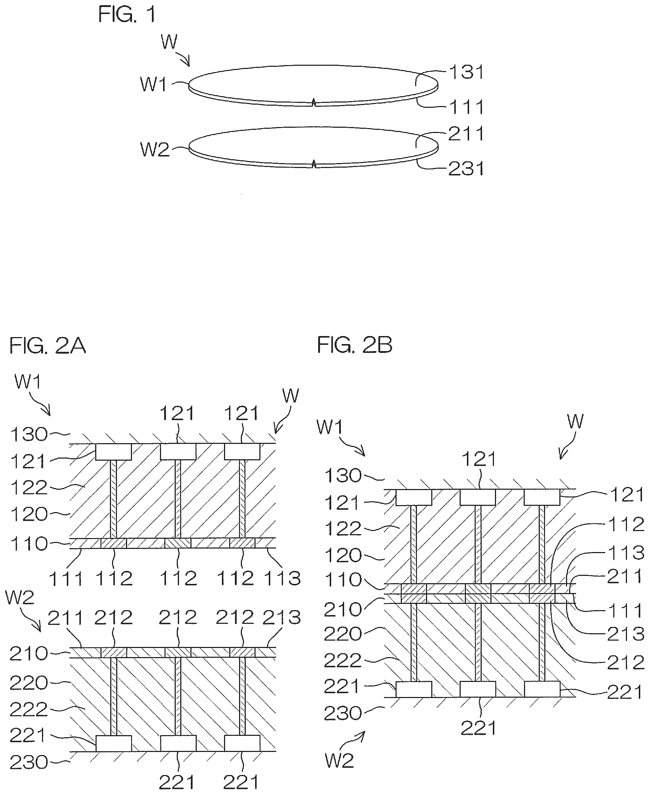

FIG. 1 is a schematic view illustrating the two substrates W before being bonded. The first substrate W1 and the second substrate W2 are flat circular substrates W having the same diameter. The diameters of the first substrate W1 and the second substrate W2 may be 300 mm or other diameters. The first substrate W1 includes a first bonding surface 111 and a first non-bonding surface 131 that are two circular planes parallel to each other, and an annular first end surface that connects the outer edges of the first bonding surface 111 and the first non-bonding surface 131. Similarly, the second substrate W2 includes a second bonding surface 211 and a second non-bonding surface 231 which are two circular flat surfaces parallel to each other, and an annular second end surface connecting the outer edges of the second bonding surface 211 and the second non-bonding surface 231. The first substrate W1 and the second substrate W2 are bonded to each other such that the first bonding surface 111 and the second bonding surface 211 face each other.

FIGS. 2A and 2B are schematic views illustrating cross-sections of the two substrates W before and after being bonded. FIGS. 2A and 2B illustrate cross-sections taken along a plane orthogonal to the two substrates W. FIG. 2A illustrates a cross-section of the two substrates W before being bonded. FIG. 2B illustrates a cross-section of the two substrates W after being bonded. FIG. 2A illustrates a cross-section of the two substrates W subjected to polishing to planarize the first bonding surface 111 and the second bonding surface 211. The ratio of each element illustrated in FIGS. 2A and 2B is not necessarily the same as the actual ratio.

As shown in FIG. 2A, the first substrate W1 includes a plurality of disk-shaped layers stacked in the thickness direction of the first substrate W1, and a disk-shaped first base material 130 that supports the plurality of layers. The plurality of layers include a disk-shaped first device layer 120 formed on the first base material 130 and a disk-shaped first bonding layer 110 formed on the first device layer 120. Similarly, the second substrate W2 includes a plurality of disk-shaped layers stacked in the thickness direction of the second substrate W2 and a disk-shaped second base material 230 that supports the plurality of layers. The plurality of layers include a disk-shaped second device layer 220 formed on the second base material 230 and a disk-shaped second bonding layer 210 formed on the second device layer 220.

The first base material 130 and the second base material 230 are made of a semiconductor such as a single crystal of silicon. The first base material 130 may be made of a material other than a semiconductor. The same applies to the second base material 230. The surface of the first base material 130 on the opposite side to the first device layer 120 corresponds to the first non-bonding surface 131 (see FIG. 1). The surface of the first bonding layer 110 on the opposite side to the first device layer 120 corresponds to the first bonding surface 111. Similarly, the surface of the second base material 230 on the opposite side to the second device layer 220 corresponds to the second non-bonding surface 231 (see FIG. 1). The surface of the second bonding layer 210 on the opposite side to the second device layer 220 corresponds to the second bonding surface 211.

Semiconductor devices such as transistors and diodes are disposed in the first device layer 120 and the second device layer 220. The first device layer 120 includes a plurality of first semiconductor devices 121 forming an electronic circuit and a first insulating film 122 electrically insulating the plurality of first semiconductor devices 121. Similarly, the second device layer 220 includes a plurality of second semiconductor devices 221 forming an electronic circuit and a second insulating film 222 electrically insulating the plurality of second semiconductor devices 221. The function of the electronic circuit of the first substrate W1 may be the same as or different from the function of the electronic circuit of the second substrate W2.

The first bonding layer 110 includes a plurality of first copper pads 112 electrically connected to the plurality of first semiconductor devices 121 of the first device layer 120 and a first insulating film 113 electrically insulating the plurality of first copper pads 112. Similarly, the second bonding layer 210 includes a plurality of second copper pads 212 electrically connected to the plurality of second semiconductor devices 221 of the second device layer 220 and a second insulating film 213 electrically insulating the plurality of second copper pads 212.

The first copper pad 112 and the second copper pad 212 are both made of copper (Cu). The first copper pad 112 is electrically insulated from the other first copper pads 112 by the first insulating film 113. Similarly, the second copper pad 212 is electrically insulated from the other second copper pads 212 by the second insulating film 213. The first insulating film 113 is made of silicon oxide (SiO₂). The second insulating film 213 is also made of silicon oxide. The first insulating film 113 and the second insulating film 213 may be a silicon oxide film made using tetraethoxysilane (TEOS) or a silicon oxide film other than this. The first insulating film 113 and the second insulating film 213 may be made of an insulating material containing silicon other than silicon oxide, such as silicon nitride (SiN) or may be made of another insulating material.

The first copper pad 112 and the first insulating film 113 are exposed at the first bonding surface 111. In other words, the first copper pad 112 and the first insulating film 113 constitute the first bonding surface 111. The first copper pad 112 and the first insulating film 113 may constitute the entire first bonding surface 111 or may constitute only a portion of the first bonding surface 111. Similarly, the second copper pad 212 and the second insulating film 213 are exposed at the second bonding surface 211. In other words, the second copper pad 212 and the second insulating film 213 constitute the second bonding surface 211. The second copper pad 212 and the second insulating film 213 may constitute the entire second bonding surface 211 or may constitute only a portion of the second bonding surface 211.

As shown in FIG. 2B, the first bonding surface 111 of the first substrate W1 and the second bonding surface 211 of the second substrate W2 are overlapped such that the plurality of first copper pads 112 and the plurality of second copper pads 212 face each other, and the first insulating film 113 and the second insulating film 213 face each other. Thereafter, the first substrate W1 and the second substrate W2 are heated. As a result, one second copper pad 212 is electrically connected to one first copper pad 112, and the first semiconductor device 121 and the second semiconductor device 221 are electrically connected via the first copper pad 112 and the second copper pad 212.

Next, an example of a procedure from processing of the substrate W with plasma to heating of the two bonded substrates W will be described.

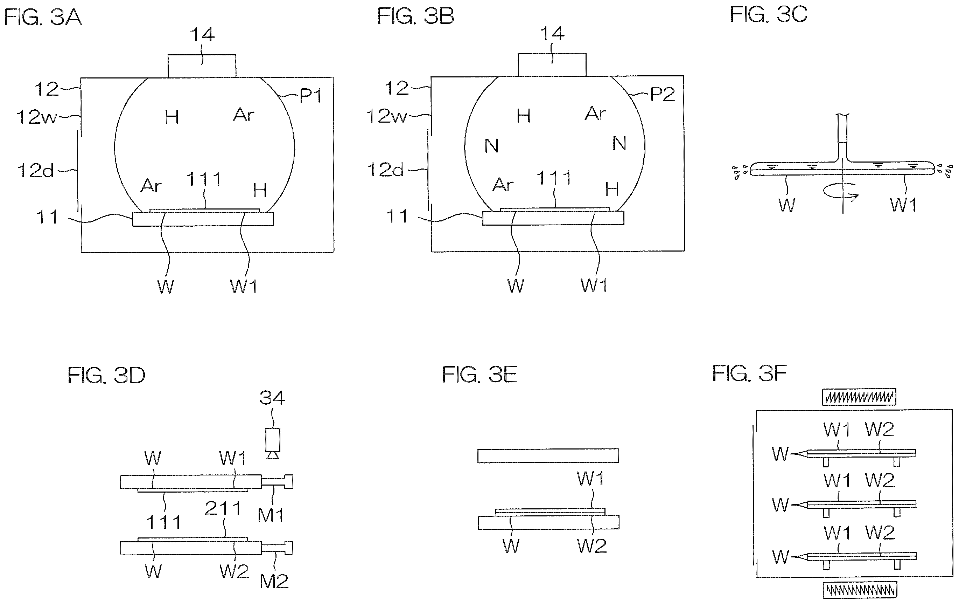

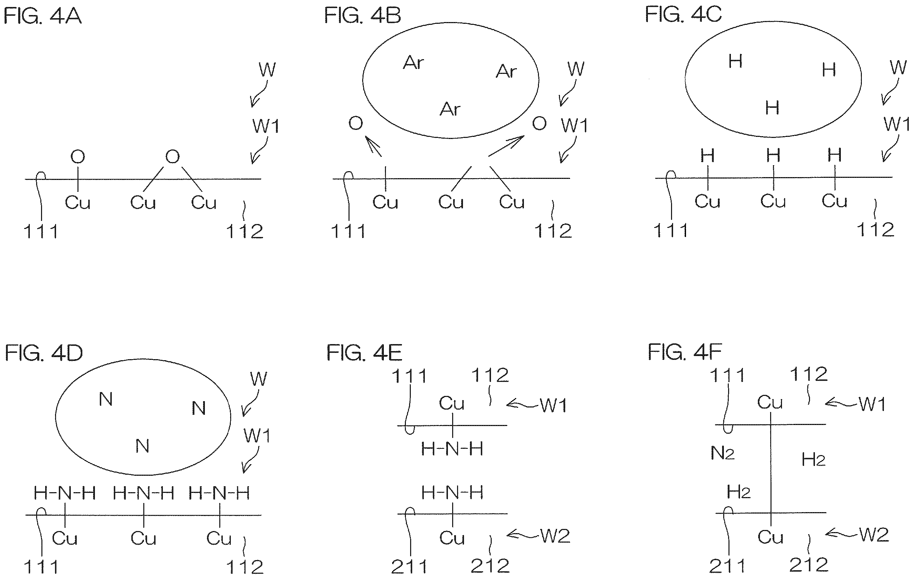

FIGS. 3A to 3F are schematic diagrams for describing the same example. FIGS. 4A to 4D are schematic diagrams for explaining an example of changes assumed to occur on the surfaces of the copper pads 112 and 212 when the substrate W is processed with plasma. FIGS. 4E to 4F are schematic diagrams for explaining an example of changes assumed to occur on the surfaces of the copper pads 112 and 212 when the substrate W is heated.

When the first substrate W1 and the second substrate W2 are bonded, the first substrate W1 and the second substrate W2 are processed with plasma. Specifically, as shown in FIG. 3A, the first substrate W1 is loaded into an airtight container 12 and supported by a substrate holder 11 disposed in the airtight container 12. FIG. 3A illustrates an example in which the first substrate W1 is horizontally supported in the airtight container 12 by the substrate holder 11 in a state where the first bonding surface 111 of the first substrate W1 faces upward.

After the first substrate W1 is supported by the substrate holder 11 and a door 12d of the airtight container 12 is closed, the gas in the airtight container 12 is discharged, and the air pressure in the airtight container 12 is reduced to a value lower than the atmospheric pressure. Thereafter, a first plasma processing step is performed in which the first bonding surface 111 of the first substrate W1 is processed with a first plasma P1 generated from the first reaction gas. Specifically, a first reaction gas, that is, the mixed gas of argon gas and hydrogen gas is supplied into the airtight container 12 in a state where the pressure in the airtight container 12 is lower than the atmospheric pressure, and then the first reaction gas in the airtight container 12 is ionized by a plasma source 14. As a result, the first reaction gas in the airtight container 12 is changed to the first plasma P1, that is, a plasma of argon and hydrogen, and the first bonding surface 111 of the first substrate W1 is exposed to the first plasma P1.

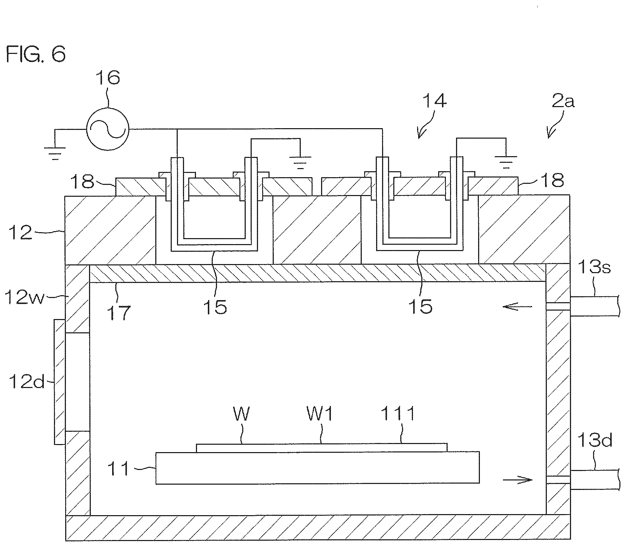

The plasma generated in the first plasma processing step may be an inductively coupled plasma or a plasma other than the inductively coupled plasma, such as a capacitively coupled plasma or a surface wave plasma. The same applies to the second plasma processing step and the third plasma processing step described below. When the first substrate W1 and the second substrate W2 are processed with the inductively coupled plasma, the inductively coupled plasma may be generated from the reaction gas in the airtight container 12 by supplying a high-frequency current to at least one antenna disposed in the airtight container 12 or at least one antenna disposed in a space in an outer wall 12w of the airtight container 12 (see FIG. 6).

As described above, the first bonding surface 111 of the first substrate W1 includes the first copper pad 112 and the first insulating film 113. As shown in FIG. 4A, the surface of the first copper pad 112 which is a portion of the first bonding surface 111 is made of copper oxide such as copper (1) oxide (cuprous oxide: Cu₂O) or copper (II) oxide (cupric oxide: CuO). In other words, the surface of the first copper pad 112 is terminated with oxygen atoms. The surface of the second copper pad 212 is also terminated with oxygen atoms. This is because copper atoms constituting the surfaces of the first copper pad 112 and the second copper pad 212 are oxidized by oxygen in air or oxygen in liquid.

As shown in FIG. 4B, an argon plasma as an example of rare gas (group 18 element) removes oxygen atoms from copper oxide forming the surface of the first copper pad 112 and converts at least one of Cu₂O and CuO into Cu. As shown in FIG. 4C, hydrogen atoms contained in the hydrogen plasma (strictly, radicals of hydrogen atoms or excited hydrogen atoms; the same applies hereinafter) are coupled to copper forming the surface of the first copper pad 112 and form Cu-H couplings on the surface of the first copper pad 112. In other words, the surface of the first copper pad 112 is terminated with hydrogen atoms. As a result, oxygen atoms exposed on the surface of the first copper pad 112 are substituted with hydrogen atoms.

After oxygen atoms exposed at the first bonding surface 111 of the first substrate W1 are substituted with hydrogen atoms, a second plasma processing step is performed in which the first bonding surface 111 of the first substrate W1 is processed with a second plasma P2 generated from a second reaction gas. Specifically, as shown in FIG. 3B, the second reaction gas, that is, the mixed gas of argon gas, hydrogen gas, and nitrogen gas is supplied into airtight container 12 in a state where the air pressure in the airtight container 12 is lower than the atmospheric pressure, and then the second reaction gas in the airtight container 12 is ionized by the plasma source 14. As a result, the second reaction gas in the airtight container 12 is changed to the second plasma P2, that is, the plasma of argon, hydrogen, and nitrogen, and the first bonding surface 111 of the first substrate W1 is exposed to the second plasma P2.

When the second reaction gas is supplied into the airtight container 12, the supply of the second reaction gas may be started after the whole first reaction gas is discharged from the airtight container 12, or the supply of the second reaction gas may be started in a state where the first reaction gas remains in the airtight container 12. In the above-described example, since the first reaction gas is the mixed gas of argon gas and hydrogen gas, and the second reaction gas is the mixed gas of argon gas, hydrogen gas, and nitrogen gas, nitrogen gas may be mixed with argon gas and hydrogen gas remaining in the airtight container 12 by supplying nitrogen gas into the airtight container 12. The supply of the second reaction gas may be started while the first reaction gas in the airtight container 12 is ionized by the plasma source 14, or the supply of the second reaction gas may be started after the plasma source 14 stops the ionization of the first reaction gas.

As described above, the oxygen atoms exposed at the first bonding surface 111 of the first substrate W1 are substituted by the hydrogen atoms. As shown in FIG. 4D, the nitrogen plasma replaces hydrogen atoms exposed on the surface of the first copper pad 112 with nitrogen atoms and forms Cu-N couplings on the surface of the first copper pad 112. If it is immediately after the hydrogen atoms are substituted with the nitrogen atoms (if the activity of the nitrogen atoms is high), at least either the hydrogen atoms cleaved from the first copper pad 112 and the like or the hydrogen atoms contained in the hydrogen plasma are coupled to the nitrogen atoms coupled to the copper atoms. As a result, as shown in FIG. 4D, Cu-NH₂ couplings are formed on the surface of the first copper pad 112. In other words, the surface of the first copper pad 112 is terminated with amino groups (NH₂).

After the surface of the first copper pad 112 is terminated with an amino group, the plasma source 14 stops the ionization of the second reaction gas in the airtight container 12. As a result, the generation of the plasma of argon, hydrogen, and nitrogen is stopped. Thereafter, the discharge of gas from the airtight container 12 is stopped while an inert gas (nitrogen gas, argon gas, or the like) is supplied into the airtight container 12. As a result, the second reaction gas and the second plasma P2 in the airtight container 12 are discharged, and the air pressure in the airtight container 12 increases to or near the atmospheric pressure. Thereafter, the door 12d of the airtight container 12 is opened, and the first substrate W1 is unloaded from the airtight container 12.

Similarly to the first bonding surface 111 of the first substrate W1, the first plasma processing step and the second plasma processing step are also performed on the second bonding surface 211 of the second substrate W2. Specifically, the second bonding surface 211 of the second substrate W2 is processed with a plasma of argon and hydrogen as the first plasma P1, and then the second bonding surface 211 of the second substrate W2 is processed with a plasma of argon, hydrogen, and nitrogen as the second plasma P2. As a result, the surface of the second copper pad 212 is terminated with amino groups. Thereafter, the second reaction gas and the second plasma P2 in the airtight container 12 are discharged, and the air pressure in the airtight container 12 is increased to or near the atmospheric pressure. Thereafter, the door 12d of the airtight container 12 is opened, and the second substrate W2 is unloaded from the airtight container 12.

When the first bonding surface 111 of the first substrate W1 is sequentially processed with the first plasma P1 and the second plasma P2, the surface of the first insulating film 113 which is a portion of the first bonding surface 111 is also sequentially processed with the first plasma P1 and the second plasma P2. Similarly, when the second bonding surface 211 of the second substrate W2 is sequentially processed with the first plasma P1 and the second plasma P2, the surface of the second insulating film 213 which is a portion of the second bonding surface 211 is also sequentially processed with the first plasma P1 and the second plasma P2. The first insulating film 113 and the second insulating film 213 are both made of silicon oxide. The oxygen atoms contained in the silicon oxide are substituted with amino groups. As a result, the surfaces of the first insulating film 113 and the second insulating film 213 are terminated with amino groups.

When the first substrate W1 is unloaded from the airtight container 12, air comes into contact with the first bonding surface 111 of the first substrate W1. Similarly, when the second substrate W2 is unloaded from the airtight container 12, air comes into contact with the second bonding surface 211 of the second substrate W2. Therefore, oxygen in the air comes into contact with the surface of the first copper pad 112. Since the surface of the first copper pad 112 is terminated with amino groups, the copper atoms forming the surface of the first copper pad 112 do not change to copper oxide even if the air comes into contact with the first bonding surface 111 of the first substrate W1. The copper atoms forming the surface of the second copper pad 212 also do not change to copper oxide. Therefore, even when air comes into contact with the first bonding surface 111 of the first substrate W1 and the second bonding surface 211 of the second substrate W2, the surface of the first copper pad 112 and the surface of the second copper pad 212 are maintained in a state of being terminated with amino groups.

Although not shown, the first substrate W1 includes at least one alignment mark serving as a reference to adjust the alignment of the first substrate W1 and the second substrate W2. The same applies to the second substrate W2. After each of the first substrate W1 and the second substrate W2 is processed with the plasma generated from the first reaction gas and the second reaction gas, as shown in FIG. 3D, an alignment check step of checking alignment representing the magnitude and direction of deviation between the first substrate W1 and the second substrate W2 is performed in a state where the first bonding surface 111 of the first substrate W1 and the second bonding surface 211 of the second substrate W2 face each other with a space therebetween. Thereafter, an alignment adjustment step of reducing the deviation amount between the first substrate W1 and the second substrate W2 is performed by relatively moving the first substrate W1 and the second substrate W2 based on the checked alignment. FIG. 3D illustrates an example of checking and adjusting the alignment of the first substrate W1 and the second substrate W2 based on images generated by the camera 34 that photographs a first mask M1 and a second mask M2 provided on a first chuck 31A that holds the first substrate W1 and a second chuck 31B that holds the second substrate W2, respectively.

After performing the second plasma processing step and before performing the alignment check step, as shown in FIG. 3C, a cleaning step may be performed in which each of the first substrate W1 and the second substrate W2 is cleaned with a cleaning liquid such as pure water, and the first substrate W1 and the second substrate W2 are dried. This makes it possible to remove particles (copper particles and the like) generated when the first substrate W1 and the second substrate W2 are processed with plasma from the first substrate W1 and the second substrate W2. Furthermore, even when oxygen in the air or oxygen in the cleaning liquid comes into contact with the first bonding surface 111 of the first substrate W1 and the second bonding surface 211 of the second substrate W2, as described above, it is possible to maintain a state in which the surface of the first copper pad 112 and the surface of the second copper pad 212 are terminated with amino groups.

After the alignment of the first substrate W1 and the second substrate W2 is adjusted, as shown in FIG. 3E, a substrate bonding step of bonding the first substrate W1 and the second substrate W2 is performed by bringing the first bonding surface 111 of the first substrate W1 and the second bonding surface 211 of the second substrate W2 into direct contact with each other under atmospheric pressure. Thereafter, as shown in FIG. 3F, a heat processing step of heating the first substrate W1 and the second substrate W2 bonded to each other is performed. FIG. 3F illustrates an example in which a plurality of sets of first substrates W1 and second substrates W2 are collectively heated. This heating is also called annealing.

If the first substrate W1 and the second substrate W2 are in contact after being heated, the first copper pad 112 of the first substrate W1 and the second copper pad 212 of the second substrate W2 may be separated from each other before the first substrate W1 and the second substrate W2 are heated. In this case, when the first substrate W1 and the second substrate W2 are heated, the first copper pad 112 and the second copper pad 212 expand and come into contact with each other. As a result, the first substrate W1 and the second substrate W2 are heated in a state where the first copper pad 112 and the second copper pad 212 are in contact with each other.

As shown in FIG. 4E, the surface of the first copper pad 112 is terminated with amino groups, and the surface of the second copper pad 212 is terminated with amino groups. When the first substrate W1 and the second substrate W2 are heated in a state where the first copper pad 112 and the second copper pad 212 are in contact with each other, two amino groups are eliminated from the surface of the first copper pad 112 and the surface of the second copper pad 212. As a result, a reaction of "Cu-NH₂ +Cu-NH₂→Cu-Cu+N₂+2H₂" (the hyphens in the reaction formula represent a coupling between two atoms) occurs, and the copper atoms forming the surface of the first copper pad 112 and the copper atoms forming the surface of the second copper pad 212 are directly coupled to each other as shown in FIG. 4F. As indicated by this chemical reaction formula, the two eliminated amino groups change into one nitrogen molecule (gas) and two hydrogen molecules (gas). Such nitrogen molecules and hydrogen molecules are discharged from between the first substrate W1 and the second substrate W2 or absorbed by the first insulating film 113 or the second insulating film 213.

The elimination of an amino group coupled to a copper atom is considered to occur at 200°C or higher. Therefore, the first substrate W1 and the second substrate W2 may be heated at 200°C or higher in the heat processing step. Specifically, the first substrate W1 and the second substrate W2 may be heated at a temperature of 200°C or higher and less than 350°C, or the first substrate W1 and the second substrate W2 may be heated at a temperature of 200°C or higher and less than 250°C. In a case where only one nitrogen atom is coupled to one copper atom instead of an amino group, the elimination of the nitrogen atom occurs when the first substrate W1 and the second substrate W2 are heated at a temperature higher than the temperature at which the amino group is eliminated. Therefore, in the case of eliminating the amino group, the heating temperature of the first substrate W1 and the second substrate W2 can be lowered as compared with the case of eliminating the nitrogen atom.

On the other hand, when the first substrate W1 and the second substrate W2 are heated in a state where the first insulating film 113 and the second insulating film 213 are in contact with each other, four hydrogen atoms are eliminated from two amino groups, that is, one amino group forming the surface of the first insulating film 113 and one amino group forming the surface of the second insulating film 213. As a result, a reaction of "Si-NH₂ +Si-NH₂→Si-N-N-Si+2H₂" (the hyphens in the reaction formula represent a coupling between two atoms.) occurs, and the silicon atoms forming the surface of the first insulating film 113 and the silicon atoms forming the surface of the second insulating film 213 are coupled via two nitrogen atoms. As shown in this chemical reaction formula, the four eliminated hydrogen atoms change into two hydrogen molecules (gas). Such hydrogen molecules are discharged from between the first substrate W1 and the second substrate W2 or absorbed by the first insulating film 113 or the second insulating film 213.

When the first substrate W1 and the second substrate W2 are heated in a state where the first bonding surface 111 of the first substrate W1 and the second bonding surface 211 of the second substrate W2 are in direct contact with each other, the above-described reaction occurs at any place of the interface between the first substrate W1 and the second substrate W2. This increases the bonding strength between the first substrate W1 and the second substrate W2. Furthermore, since the two copper atoms are directly coupled at the interface between the first copper pad 112 and the second copper pad 212, the electrical resistance can be reduced as compared with the case where copper oxide is interposed between the two copper atoms.

In the above example, the first reaction gas is the mixed gas of argon gas and hydrogen gas, and the second reaction gas is the mixed gas of argon gas, hydrogen gas, and nitrogen gas, but the composition of the first reaction gas and the second reaction gas is not limited thereto as long as the terminal oxygen atom can be substituted with an amino group. The number of times of processing the first bonding surface 111 of the first substrate W1 and the second bonding surface 211 of the second substrate W2 with plasma (the number of times of the plasma processing step) may be 1 or 3.

For example, in the above-described example, the second plasma processing step may be omitted, and the first bonding surface 111 of the first substrate W1 and the second bonding surface 211 of the second substrate W2 may be processed with a plasma of argon, hydrogen, and nitrogen.

In the above-described example, the first reaction gas may be the mixed gas of argon gas and hydrogen gas, and the second reaction gas may be nitrogen gas. The first reaction gas may be argon gas, and the second reaction gas may be argon gas, hydrogen gas, and nitrogen gas.

In the above-described example, a third plasma processing step of processing the first bonding surface 111 of the first substrate W1 or the second bonding surface 211 of the second substrate W2 with the third plasma generated from the third reaction gas may be performed after performing the first plasma processing step and the second plasma processing step and before performing the heat processing step. In this case, the first reaction gas may be argon gas, the second reaction gas may be hydrogen gas or the mixed gas of argon gas and hydrogen gas, and the third reaction gas may be nitrogen gas, the mixed gas of hydrogen gas and nitrogen gas, or the mixed gas of argon gas, hydrogen gas, and nitrogen gas.

Next, a substrate bonding apparatus 1 that performs the above-described steps will be described.

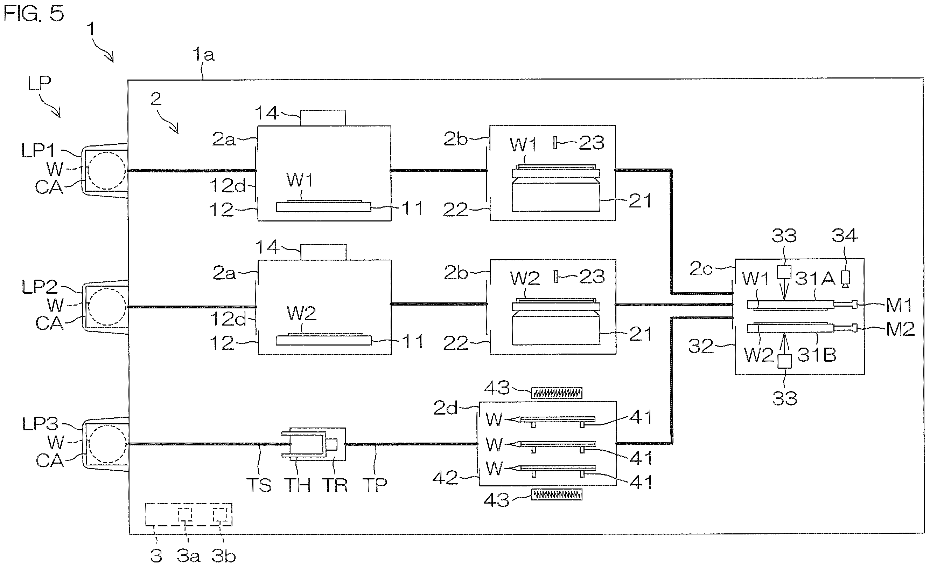

FIG. 5 is a schematic view of the substrate bonding apparatus 1. FIG. 6 is a schematic view showing a vertical cross-section of a plasma processing unit 2a.

The substrate bonding apparatus 1 is an apparatus that bonds two disk-shaped substrates W such as semiconductor wafers. As shown in FIG. 5, the substrate bonding apparatus 1 includes a plurality of load ports LP on each of which a carrier CA housing a plurality of substrates W such as a FOUP (front-opening unified pod) is placed, a plurality of processing units 2 that process the substrates W transferred from the plurality of load ports LP, a transfer system TS that transfers the substrates W between the plurality of load ports LP and the plurality of processing units 2, and an outer wall 1a that forms a sealed space housing the plurality of processing units 2 and the transfer system TS. the substrate bonding apparatus 1 further includes a controller 3 that controls the substrate bonding apparatus 1.

FIG. 5 illustrates an example in which three load ports LP are provided. The three load ports LP include a first load port LP1 on which the carrier CA accommodating the first substrate W1 is placed, a second load port LP2 on which a carrier CA accommodating the second substrate W2 is placed, and a third load port LP3 on which a carrier CA accommodating the bonded first substrate W1 and second substrate W2 are placed. The first load port LP1 and the second load port LP2 are load ports on which the carriers CA accommodating the substrates W to be bonded by the substrate bonding apparatus 1 are placed. The third load port LP3 is an unloading port where the carrier CA accommodating the two substrates W bonded by the substrate bonding apparatus 1 is placed.

The transfer system TS transfers the substrate W from the first load port LP1 and the second load port LP2 to the plurality of processing units 2 and transfers the substrates W from the plurality of processing units 2 to the third load port LP3. The transfer system TS further transfers the substrate W between the plurality of processing units 2. The transfer system TS may include at least one transfer robot TR that transfers one or more substrates W in a horizontal posture on a transfer path TP indicated by the thick lines in FIG. 5.

The transfer robot TR includes at least one hand TH that holds one substrate W in a horizontal posture. The transfer robot TR moves along the transfer path TP while horizontally holding the substrate W with the hand TH. FIG. 5 illustrates an example in which the transfer path TP extends from each of the first load port LP1 and the second load port LP2 to the plurality of processing units 2 and returns from the plurality of processing units 2 to the third load port LP3.

The plurality of processing units 2 include a plasma processing unit 2a, a cleaning unit 2b, a bonding unit 2c, and a heat processing unit 2d. FIG. 5 illustrates an example in which two plasma processing units 2a and two cleaning units 2b are provided. Unless otherwise specified, the bonding unit 2c described in the present specification bonds the substrates W under atmospheric pressure.

The plasma processing unit 2a is a unit that performs a plasma processing step such as the first plasma processing step, the second plasma processing step, and the third plasma processing step described above. The cleaning unit 2b is a unit that dries the substrate W after cleaning the substrate W with a cleaning liquid such as pure water. The bonding unit 2c is a unit that bonds two substrates W by bringing the two substrates W into contact with each other. The heat processing unit 2d is a unit that performs the above-described heat processing step.

The plasma processing unit 2a, the cleaning unit 2b, and the bonding unit 2c are single substrate processing type units that process the substrates W one by one (note, however that, for the bonding unit 2c, one set of the first substrate W1 and the second substrate W2 is regarded as one substrate W). The heat processing unit 2d may be a single substrate processing type unit that processes the bonded substrates W one by one or may be a batch type unit that collectively processes a plurality of bonded substrates W. One bonded substrate W is one pair of the first substrate W1 and the second substrate W2 bonded together.

The cleaning unit 2b includes a spin chuck 21 that rotates the substrate W around a vertical straight line passing through the central portion of the substrate W while horizontally holding one substrate W, a chamber 22 that accommodates the substrate W held by the spin chuck 21, and a cleaning liquid nozzle 23 that discharges a cleaning liquid toward the substrate W held by the spin chuck 21.

The bonding unit 2c includes the first chuck 31A that holds the first substrate W1, the second chuck 31B that holds the second substrate W2, and a chamber 32 that accommodates the first substrate W1 and the second substrate W2 held by the first chuck 31A and the second chuck 31B. The first chuck 31A includes a first mask M1, and the second chuck 31B includes a second mask M2, respectively. The first mask M1 and the second mask M2 each are made of a member that transmits visible light, such as glass. The bonding unit 2c further includes at least one actuator 33 that relatively moves the first chuck 31A and the second chuck 31B and a camera 34 that photographs the first mask M1 and the second mask M2 to check the alignment of the first substrate W1 and the second substrate W2. Note that the positional relationship between the first mask M1 and the first substrate W1 and the positional relationship between the second mask M2 and the second substrate W2 may be separately detected by a camera (not illustrated) or may be defined on the basis of positioning members (positioning pins or the like) provided on the first mask M1 and the second mask M2.

At least one actuator 33 of the bonding unit 2c adjusts the alignment of the first substrate W1 and the second substrate W2 by relatively moving the first chuck 31A and the second chuck 31B. The at least one actuator 33 further bonds the first substrate W1 and the second substrate W2 by relatively moving the first chuck 31A and the second chuck 31B. The actuator is a device that converts driving energy, which represents electrical, fluid, magnetic, thermal or chemical energy, to mechanical work, that is, motion of a tangible object. The actuator includes an electric motor (rotary motor), linear motor, air cylinder and other devices.

FIG. 5 shows an example in which the heat processing unit 2d is of a batch type. Regardless of whether the heat processing unit 2d is of a single substrate processing type or a batch type, the heat processing unit 2d includes a substrate holder 41 that holds the two bonded substrates W, a heat processing furnace 42 that accommodates the two substrates W held by the substrate holder 41, and a heater 43 that raises the temperature in the heat processing furnace 42.

As shown in FIG. 6, the plasma processing unit 2a includes the substrate holder 11 that supports the first substrate W1 or the second substrate W2 and the airtight container 12 that accommodates the first substrate W1 or the second substrate W2 supported by the substrate holder 11. The plasma processing unit 2a further includes an exhaust pipe 13d that guides the gas discharged from the airtight container 12, a gas supply pipe 13s that guides the gas to be supplied to the airtight container 12 such as the reaction gas, and the plasma source 14 that generates plasma from the reaction gas in the airtight container 12. The airtight container 12 includes an outer wall 12w in which an internal space to accommodate the first substrate W1 or the second substrate W2 and a passing port through which the first substrate W1 or the second substrate W2 passes into and out of the internal space are formed and the door 12d to open and close the passing port.

FIG. 6 illustrates an example in which the plasma source 14 generates an inductively coupled plasma. The plasma source 14 includes at least one antenna 15 corresponding to a coil and a high-frequency power supply 16 that supplies a high-frequency current to at least one antenna 15. FIG. 6 illustrates an example in which the two antennas 15 are arranged in two spaces in the outer wall 12w. In this example, the antenna 15 is disposed in a space between the inner plate 17 that closes a hole opened in the inner surface of the outer wall 12w and an outer plate 18 that closes a hole opened in the outer surface of the outer wall 12w.

The high-frequency power supply 16 supplies a high-frequency current to the antenna 15 in a state where the air pressure in the space between the inner plate 17 and the outer plate 18 has decreased to a value lower than the atmospheric pressure. When the high-frequency current is supplied to the antenna 15, an induced electric field is generated in the airtight container 12, and the reaction gas in the airtight container 12 is ionized. As a result, plasma is generated. The embedded antenna 15 disposed in the outer wall 12w of the airtight container 12 is electrically insulated from the plasma by the inner plate 17 as a dielectric.

FIG. 6 illustrates an example in which the U-shaped antenna 15 is arranged in a vertical plane in an upwardly open posture. The U-shaped antenna 15 includes two parallel portions parallel or substantially parallel to each other and a connection portion (a portion extending left and right in FIG. 6) connecting the two parallel portions. The connection portion of the antenna 15 is disposed in a space in the outer wall 12w. The area of the space inside the antenna 15 corresponds to the area of the antenna 15. The area of the antenna 15 is smaller than the area of the first bonding surface 111 of the first substrate W. The inductance of the antenna 15 decreases as the area of the antenna 15 decreases. The area of the antenna 15 may be equal to or larger than the area of the first bonding surface 111. The antenna 15 may be maintained in a horizontal posture. The antenna 15 may be disposed inside or outside the airtight container 12. The number of windings of the coil-shaped antenna 15 may be 1 or more.

A controller 3 (see FIG. 5) controls electric devices and electronic devices provided in the substrate bonding apparatus 1. The controller 3 includes a processor 3a that performs processing of information such as execution of a program and a memory 3b that stores information such as a program to be executed by the processor 3a. The controller 3 controls the substrate bonding apparatus 1 and transfers and processes the substrate W described above. In other words, the controller 3 is programmed to perform the above-described transfer and processing of the substrate W. The controller 3 controls the substrate bonding apparatus 1 and performs each process from the plasma processing step to the heat processing step described with reference to FIGS. 1 to 4F. Note that the processor 3a may be any one of a central processing unit (CPU), a micro processing unit (MPU), a graphics processing unit (GPU), and a digital signal processor (DSP), or a combination thereof. Alternatively, the processor 3a may include a field-programmable gate array (FPGA) or an application specific integrated circuit (ASIC).

Next, the advantages according to the embodiment will be described.

In the present embodiment, the bonding surfaces 111 and 211 of the copper pads 112 and 212 where the copper oxide and the insulating films 113 and 213 are exposed are processed with a rare gas plasma (a plasma of a rare gas), a hydrogen plasma (a plasma of hydrogen), and a nitrogen plasma (a plasma of nitrogen). Argon is an example of a rare gas (group 18 element). The rare gas plasma removes oxygen atoms from the copper oxide of the copper pads 112 and 212 and converts the copper oxide into copper atoms. The hydrogen plasma couples hydrogen atoms to the copper atoms of the copper pads 112 and 212. The nitrogen plasma replaces the hydrogen atoms coupled to the copper atoms of the copper pads 112 and 212 with nitrogen atoms and couples the nitrogen atoms to the copper atoms. Since the activity of the nitrogen atoms is high immediately after being coupled to the copper atoms, the hydrogen atoms on the bonding surfaces 111 and 211 such as the hydrogen atoms separated from the copper atoms are coupled to the nitrogen atoms. As a result, amino groups are coupled to copper atoms, and the surfaces of the copper pads 112 and 212 are terminated with the amino groups.

After the bonding surfaces 111 and 211 of the respective substrates W are processed with plasma, the bonding surfaces 111 and 211 of the two substrates W are brought into contact with each other. As a result, the copper pads 112 and 212 of the two substrates W face each other, and the insulating films 113 and 213 of the two substrates W face each other. As described above, the surfaces of the copper pads 112 and 212 are terminated with amino groups. Thus, the two amino groups are located between the two copper atoms. When the two bonded substrates W are heated, amino groups are eliminated from the interface between the two copper pads 112 and 212, and the copper atoms of the two copper pads 112 and 212 are directly coupled to each other. Therefore, the electrical resistance of the interface between the two bonded copper pads 112 and 212 can be reduced as compared with the case where copper oxide is present at the interface.

In the present embodiment, the bonding surfaces 111 and 211 of the respective substrates W are processed with a plasma containing a rare gas plasma and not containing a nitrogen plasma. Thereafter, the bonding surfaces 111 and 211 of the respective substrates W are processed with a nitrogen plasma. The hydrogen plasma processing which is the processing of the bonding surfaces 111 and 211 with a hydrogen plasma may be performed before or simultaneously with the nitrogen plasma processing which is the processing of the bonding surfaces 111 and 211 with a nitrogen plasma. In the former case, a hydrogen plasma processing may be performed simultaneously with rare gas plasma processing, which is the processing of the bonding surfaces 111 and 211 by a rare gas plasma.

If the bonding surfaces 111 and 211 of the substrates W are processed with a plasma containing a rare gas plasma and a nitrogen plasma and not containing a hydrogen plasma before oxygen atoms are removed from copper oxide, there is a case where, after oxygen atoms are removed from copper oxide, nitrogen atoms are stabilized in a state of being coupled to copper atoms. In other words, copper nitride (Cu₃N) may be generated on the surfaces of the copper pads 112 and 212. Even when the bonding surfaces 111 and 211 of the substrates W are processed with a hydrogen plasma after the coupling between the nitrogen atom and the copper atom is stabilized, the nitrogen atom does not change or hardly changes to an amino group. Further, the nitrogen atoms contained in the copper nitride are not eliminated from the interfaces between the two copper pads 112 and 212 unless the two substrates W are heated at a higher temperature than in the case of eliminating the amino group.

As described above, when the bonding surfaces 111 and 211 of the respective substrates W are processed with the rare gas plasma, the hydrogen plasma, and the nitrogen plasma, the probability that the hydrogen atom couples to the copper atom before the nitrogen atom couples to the copper atom increases. If the hydrogen atoms are coupled to the copper atoms first, the surfaces of the copper pads 112, 212 can be terminated with amino groups. This makes it possible to prevent copper nitride from being generated on the surfaces of the copper pads 112 and 212 or to reduce copper nitride generated on the surfaces of the copper pads 112 and 212.

In the present embodiment, the first reaction gas containing a rare gas and hydrogen and not containing nitrogen is supplied into the airtight container 12 accommodating the substrate W, and the first plasma P1 containing a rare gas and hydrogen and not containing nitrogen is generated from the first reaction gas. As a result, oxygen atoms contained in copper oxide are substituted with hydrogen atoms. Thereafter, the second reaction gas containing at least nitrogen is supplied into the airtight container 12, and the second plasma P2 containing at least nitrogen is generated from the second reaction gas. As a result, amino groups are coupled to copper atoms constituting the surfaces of the copper pads 112 and 212. The second reaction gas may be a gas (for example, nitrogen gas) not containing a rare gas and hydrogen or may be a gas containing one or both of the rare gas and hydrogen in addition to nitrogen. In the latter case, when copper oxide remains on the surfaces of the copper pads 112 and 212, oxygen atoms contained in the copper oxide are substituted with hydrogen atoms, and then the hydrogen atoms are substituted with amino groups.

The first reaction gas differs from the second reaction gas in that the first reaction gas does not contain nitrogen. Therefore, even if the mixed gas of the rare gas, the hydrogen gas, and the nitrogen gas is not supplied into the airtight container 12, the second reaction gas can be supplied into the airtight container 12 by adding the nitrogen gas to the first reaction gas in the airtight container 12. Therefore, it is not necessary to discharge the first reaction gas from the airtight container 12 before starting the supply of the second reaction gas. Further, when nitrogen gas is added to the first reaction gas in the airtight container 12 while the gas in the airtight container 12 is ionized by the plasma source 14, it is possible to continuously switch from the first plasma processing step to the second plasma processing step.

In the present embodiment, oxygen is brought into contact with the bonding surfaces 111 and 211 of the substrates W processed with plasma. Specifically, a gas containing oxygen such as air is brought into contact with the substrate W, or a liquid in which oxygen is dissolved is brought into contact with the substrate W. The transfer system TS and the cleaning unit 2b are examples of oxygen contact units. Even if copper oxide is removed from the surfaces of the copper pads 112 and 212, when oxygen atoms or oxygen molecules come into contact with the surfaces of the copper pads 112 and 212, the copper atoms are oxidized on the surfaces of the copper pads 112 and 212 before bonding the two substrates W. Such oxidation can be prevented or reduced when the surfaces of the copper pads 112, 212 are terminated with amino groups. Therefore, it is not necessary to bond the two substrates W in vacuum or to transfer each of the substrates W by the transfer robot TR in vacuum.

In the present embodiment, the bonding surfaces 111 and 211 of the substrates W processed with plasma are cleaned with a cleaning liquid and dried. Even if oxygen is dissolved in the cleaning liquid, since the surfaces of the copper pads 112 and 212 are terminated with amino groups, it is possible to inhibit or prevent the copper atoms from being oxidized by oxygen in the cleaning liquid on the surfaces of the copper pads 112 and 212. Furthermore, since the cleaning liquid is supplied to the bonding surfaces 111 and 211 of the substrates W, particles generated when the bonding surfaces 111 and 211 of the substrate W are processed with plasma can be reduced. This makes it possible to reduce particles remaining at the interface between the two bonded substrates W.

In the present embodiment, the two bonded substrates W are heated. By this heating, amino groups are eliminated from the interface between the two copper pads 112 and 212, and the copper atoms of the two copper pads 112 and 212 are directly coupled to each other. Therefore, the electrical resistance of the interface between the two bonded copper pads 112 and 212 can be reduced as compared with the case where copper oxide is present at the interface. Furthermore, the heating temperature of the two substrates W can be lowered as compared with the case where copper oxide is caused to disappear from the interface between the two copper pads 112 and 212 by heating the two bonded substrates W.

In the present embodiment, the plasma processing and the bonding of the substrates W are performed by one substrate bonding apparatus 1. Specifically, the plasma processing unit 2a of the substrate bonding apparatus 1 performs plasma processing on each of the two substrates W, and thereafter, the bonding unit 2c of the substrate bonding apparatus 1 bonds the two substrates W. After bonding the two substrates W, the heat processing unit 2d of the substrate bonding apparatus 1 heats the two substrates W. By this heating, amino groups are eliminated from the interface between the two copper pads 112 and 212. Since not only the plasma processing and the bonding of the substrates W but also heat processing are performed by one substrate bonding apparatus 1, the period from the end of the plasma processing to the start of the heat processing can be shortened. Therefore, the number of amino groups that are altered or eliminated during this period can be reduced.

In the present embodiment, by supplying a high-frequency current to the antenna 15, an induced electric field is generated in the airtight container 12 accommodating the substrate W. As a result, the gas in the airtight container 12 is ionized, and an inductively coupled plasma of at least one of rare gas, hydrogen, and nitrogen is generated. The inductively coupled plasma comes into contact with the bonding surfaces 111 and 211 of the substrates W in the airtight container 12, whereby the bonding surfaces 111 and 211 are processed. An inductively coupled plasma is a high-density plasma with a high density of electrons, ions, radicals and the like. Therefore, the bonding surfaces 111 and 211 of the substrates W can be uniformly processed.

The antenna 15 is disposed in a space between the inner plate 17 that closes the hole opened in the inner surface of the outer wall 12w of the airtight container 12 and the outer plate 18 that closes the hole opened in the outer surface of the outer wall 12w of the airtight container 12. The antenna 15 is limited to a size that can be disposed in the space in the outer wall 12w. As a result, the antenna 15 can be downsized, and the inductance of the antenna 15 can be reduced. When the inductance of the antenna 15 is low, the voltage applied to the antenna 15 when the high-frequency current is supplied to the antenna 15 decreases, and damage to the substrate W due to the plasma is reduced. This makes it possible to uniformly process the bonding surfaces 111 and 211 with plasma while reducing damage.

Next, other embodiments will be described.

The rare gas (group 18 element) contained in the reaction gas to generate plasma may be a rare gas other than argon, such as helium or neon.

At least one of the plasma processing unit 2a and the heat processing unit 2d may be a device different from the substrate bonding apparatus 1. That is, at least one of the plasma processing unit 2a and the heat processing unit 2d may be disposed outside the outer wall 1a of the substrate bonding apparatus 1.

Two or more arrangements among all the arrangements described above may be combined. Two or more steps among all the steps described above may be combined.

The embodiments of the present invention are described in detail above, however, these are just detailed examples used for clarifying the technical contents of the present invention, and the present invention should not be limitedly interpreted to these detailed examples, and the spirit and scope of the present invention should be limited only by the claims appended hereto.

This application claims the benefit of priority to Japanese Patent Application No. 2024-043677 filed on March 19, 2024. The entire contents of this application are hereby incorporated herein by reference.

## Claims

1. A substrate bonding method that bonds two substrates (W1, W2) each having a bonding surface (111, 211) where a copper oxide of a copper pad (112, 212) and an insulating film (113, 213) are exposed, the substrate bonding method comprising:
a plasma processing step of processing the bonding surface (111, 211) of each of the substrates (W1, W2) with a rare gas plasma which is a plasma of a rare gas, processing the bonding surface (111, 211) of each of the substrates (W1, W2) processed with the rare gas plasma with a hydrogen plasma which is a plasma of hydrogen, and processing the bonding surface (111, 211) of each of the substrates (W1, W2) processed with the hydrogen plasma with a nitrogen plasma which is a plasma of nitrogen; and
a substrate bonding step of bonding the two substrates (W1, W2) by bringing the bonding surfaces (111, 211) of the two substrates (W1, W2) into contact with each other such that the copper pads (112, 212) of the two substrates (W1, W2) face each other and the insulating films (113, 213) of the two substrates (W1, W2) face each other after the plasma processing step.

2. The substrate bonding method according to claim 1, wherein the plasma processing step is a step of performing, on each of the two substrates (W1, W2), a rare gas plasma processing step of processing the bonding surface (111, 211) with a plasma containing the rare gas plasma and not containing the nitrogen plasma, a nitrogen plasma processing step of processing the bonding surface (111, 211) with the nitrogen plasma, and a hydrogen plasma processing step of processing the bonding surface (111, 211) with the hydrogen plasma simultaneously with at least one of the rare gas plasma processing step and the nitrogen plasma processing step, or after the rare gas plasma processing step and before the nitrogen plasma processing step.

3. The substrate bonding method according to claim 2, wherein the plasma processing step is a step of performing, on each of the two substrates (W1, W2), a first plasma processing step of supplying a first reaction gas containing the rare gas and hydrogen and not containing the nitrogen into an airtight container (12) accommodating the substrate (W1, W2) and processing the bonding surface (111, 211) with a first plasma generated from the first reaction gas, and a second plasma processing step of supplying a second reaction gas containing the nitrogen into the airtight container (12) and processing the bonding surface (111, 211) with a second plasma generated from the second reaction gas.

4. The substrate bonding method according to any one of claims 1 to 3, further comprising an oxygen contact step of bringing at least one of oxygen in atmosphere and oxygen in a liquid into contact with the bonding surface (111, 211) of each of the substrates (W1, W2) after the plasma processing step is performed.

5. The substrate bonding method according to claim 4, wherein the oxygen contact step includes a cleaning step of cleaning with a cleaning liquid and drying each of the two substrates (W1, W2) after the plasma processing step is performed and before the substrate bonding step is performed.

6. The substrate bonding method according to any one of claims 1 to 5, further comprising a heat processing (2d) step of heating the two bonded substrates (W1, W2) to directly couple copper contained in the copper pad (112, 212) of one of the two substrates (W1, W2) to copper contained in the copper pad (112, 212) of the other of the two substrates (W1, W2).

7. The substrate bonding method according to claim 6, wherein the plasma processing step is a step of processing the bonding surface (111, 211) of each of the substrates (W1, W2) with the rare gas plasma, the hydrogen plasma, and the nitrogen plasma by causing a plasma processing unit (2a) of a substrate bonding apparatus (1) to generate the rare gas plasma, the hydrogen plasma, and the nitrogen plasma,
the substrate bonding step is a step of bonding the two substrates (W1, W2) by causing a bonding unit (2c) of the substrate bonding apparatus (1) to bring the bonding surfaces (111, 211) of the two substrates (W1, W2) into contact with each other such that the copper pads (112, 212) of the two substrates (W1, W2) face each other and the insulating films (113, 213) of the two substrates (W1, W2) face each other, and
the heat processing (2d) step is a step of directly coupling copper contained in the copper pad (112, 212) of one of the two substrates (W1, W2) and copper contained in the copper pad (112, 212) of the other of the two substrates (W1, W2) by causing a heat processing (2d) unit of the substrate bonding apparatus (1) to heat the bonded two substrates (W1, W2).

8. The substrate bonding method according to any one of claims 1 to 7, wherein the plasma processing step is a step of generating an inductively coupled plasma of at least one of the rare gas, hydrogen, and nitrogen by supplying a high-frequency current to an antenna (15) disposed in a space between an inner plate (17) that closes a hole opened in an inner surface of an outer wall (12w) of an airtight container (12) accommodating the substrate (W1, W2) and an outer plate (18) that closes a hole opened in an outer surface of the outer wall (12w).

9. A substrate bonding apparatus (1) that bonds two substrates (W1, W2) each having a bonding surface (111, 211) where a copper oxide of a copper pad (112, 212) and an insulating film (113, 213) are exposed, the substrate bonding apparatus (1) comprising:
a plasma processing unit (2a) configured to process the bonding surface (111, 211) of each of the substrates (W1, W2) with a rare gas plasma which is a plasma of a rare gas, process the bonding surface (111, 211) of each of the substrates (W1, W2) processed with the rare gas plasma with a hydrogen plasma which is a plasma of hydrogen, and process the bonding surface (111, 211) of each of the substrates (W1, W2) processed with the hydrogen plasma with a nitrogen plasma which is a plasma of nitrogen; and
a substrate bonding unit (2c) configured to bond the two substrates (W1, W2) by bringing the bonding surfaces (111, 211) of the two substrates (W1, W2) into contact with each other such that the copper pads (112, 212) of the two substrates (W1, W2) face each other and the insulating films (113, 213) of the two substrates (W1, W2) face each other after the bonding surface (111, 211) of each of the substrates (W1, W2) is processed with the rare gas plasma, the hydrogen plasma, and the nitrogen plasma.

10. The substrate bonding apparatus (1) according to claim 9, wherein the plasma processing unit (2a) performs, on each of the two substrates (W1, W2), a rare gas plasma processing step of processing the bonding surface (111, 211) with a plasma containing the rare gas plasma and not containing the nitrogen plasma, a nitrogen plasma processing step of processing the bonding surface (111, 211) with the nitrogen plasma, and a hydrogen plasma processing step of processing the bonding surface (111, 211) with the hydrogen plasma simultaneously with at least one of the rare gas plasma processing step and the nitrogen plasma processing step, or after the rare gas plasma processing step and before the nitrogen plasma processing step.

11. The substrate bonding apparatus (1) according to claim 10, wherein the plasma processing unit (2a) performs, on each of the two substrates (W1, W2), a first plasma processing step of supplying a first reaction gas containing the rare gas and hydrogen and not containing nitrogen into an airtight container (12) containing the substrate (W1, W2) and processing the bonding surface (111, 211) with a first plasma generated from the first reaction gas and a second plasma processing step of supplying a second reaction gas containing nitrogen into the airtight container (12) and processing the bonding surface (111, 211) with a second plasma generated from the second reaction gas.

12. The substrate bonding apparatus (1) according to any one of claims 9 to 11, further comprising an oxygen contact unit (TS, 2b) configured to bring at least one of oxygen in atmosphere and oxygen in a liquid into contact with the bonding surface (111, 211) of each of the substrates (W1, W2) after the bonding surface (111, 211) of each of the substrates (W1, W2) is processed with the rare gas plasma, the hydrogen plasma, and the nitrogen plasma.

13. The substrate bonding apparatus (1) according to claim 12, wherein the oxygen contact unit (TS, 2b) includes a cleaning unit (2b) configured to clean with a cleaning liquid and dry each of the two substrates (W1, W2) after the bonding surface (111, 211) of each of the substrates (W1, W2) is processed with the rare gas plasma, the hydrogen plasma, and the nitrogen plasma and before the two substrates (W1, W2) are bonded.

14. The substrate bonding apparatus (1) according to any one of claims 9 to 13, further comprising a heat processing (2d) unit configured to heat the two bonded substrates (W1, W2) and directly couple copper contained in the copper pad (112, 212) of one of the two substrates (W1, W2) to copper contained in the copper pad (112, 212) of the other of the two substrates (W1, W2).

15. The substrate bonding apparatus (1) according to any one of claims 9 to 14, wherein the plasma processing unit (2a) generates an inductively coupled plasma of at least one of the rare gas, hydrogen, and nitrogen by supplying a high-frequency current to an antenna (15) disposed in a space between an inner plate (17) that closes a hole opened in an inner surface of an outer wall (12w) of an airtight container (12) accommodating the substrate (W1, W2) and an outer plate (18) that closes a hole opened in an outer surface of the outer wall (12w).
